# EUROPÄISCHE PATENTSCHRIFT

(11) **EP 1 231 638 B1**
(45) Veröffentlichungstag und Bekanntmachung des Hinweises auf die Patenterteilung: **13.10.2004**
(21) Anmeldenummer: 01103187.9
(22) Anmeldetag: 10.02.2001
(51) Int. Cl.: H01L 23/528

(54) **Stromversorgungsleiter-Struktur in einer integrierten Halbleiterschaltung**
Power supply wiring of an integrated circuit
Configuration de lignes d'alimentation pour dispositif semi-conducteur

(43) Veröffentlichungstag der Anmeldung: 14.08.2002
(73) Patentinhaber: TOSHIBA Electronics Europe GmbH, 40549 Düsseldorf (DE)
(72) Erfinder: Wevelsiep, Martin, 41564 Kaarst (DE); Lehmann, Ernst, 45699 Herten (DE)
(74) Vertreter: Stenger, Watzke & Ring Patentanwälte

(56) Entgegenhaltungen:
- EP-A- 0 532 305
- US-A- 5 145 800
- PATENT ABSTRACTS OF JAPAN vol. 1997, no. 04, 30. April 1997 (1997-04-30) -& JP 08 321551 A (HITACHI LTD), 3. Dezember 1996 (1996-12-03)
- PATENT ABSTRACTS OF JAPAN vol. 010, no. 201 (E-419), 15. Juli 1986 (1986-07-15) -& JP 61 043445 A (HITACHI LTD), 3. März 1986 (1986-03-03)
- PATENT ABSTRACTS OF JAPAN vol. 010, no. 129 (E-403), 14. Mai 1986 (1986-05-14) -& JP 60 258935 A (NIPPON DENKI KK), 20. Dezember 1985 (1985-12-20)
- PATENT ABSTRACTS OF JAPAN vol. 016, no. 073 (E-1169), 21. Februar 1992 (1992-02-21) -& JP 03 263854 A (FUJITSU LTD), 25. November 1991 (1991-11-25)

## Beschreibung

Die vorliegende Erfindung betrifft eine integrierte Schaltung mit einem Stapel aus einer Vielzahl von einzelnen Lagen aus Schaltungselementen, Stromleitungen und/oder Signalleitungen aufweisenden Flächenelementen, wobei wenigstens eine Lage Stromleitungen aufweist, die zueinander isoliert Ströme führende Doppelleitungen sind und die Stromleitungen einer Lage mit im Randbereich der Lage ausgebildeten Verteilern und die Stromleitungen verschiedener Lagen elektrisch miteinander verbunden sind. Weiterhin betrifft die Erfindung ein Verfahren zur Herstellung derartiger Schaltungen.

Integrierte Schaltungen der gattungsgemäßen Art und Verfahren zu deren Herstellung sind an sich bekannt. Solche Schaltungen in Form von mikroelektronischen Bauelementen sind beispielsweise als Chips in einer Vielzahl von elektronischen Anwendungen im Einsatz.

Üblicherweise werden Halbleitermaterialien, beispielsweise Silizium, flächenförmig ausgebildet, wobei man von Lagen bzw. Layern spricht. Durch unterschiedliche Verfahren werden auf diesen Layem Schaltungselemente ausgebildet, beispielsweise Transistoren, und es werden je nach Bedarf und Anwendung Signalleitungen für die Datenübertragung und/oder Stromleitungen für die Stromzufuhr ausgebildet. Für mit Leitungen versehene Lagen können auch andere als Halbleitermaterialien verwendet werden. Die Lagen bzw. Layer haben üblicherweise eine rechteckige, vorzugsweise quadratische Geometrie und werden nach schaltungstechnischen Gesichtspunkten zu einer integrierten Schaltung übereinander angeordnet. Derartige Stapel werden auch mit dem englischen Wort "die" bezeichnet. Die Kontaktierung der Schaltung erfolgt über den Randbereich des "die", wobei insbesondere bei den Lagen mit stromführenden Leitungen an deren Randbereichen Verteiler ausgebildet werden.

Es ist bekannt, die Verteiler solcher Lagen umlaufend am Rand der Lage auszubilden und zu beschalten. Die stromführenden Leitungen werden dann üblicherweise zueinander parallel von einem in einem Randbereich liegenden Verteiler zu dem am gegenüberliegenden Rand angeordneten Verteiler geführt. Nach schaltungstechnischen Gesichtspunkten werden dann die stromführenden Leitungen verschiedener Lagen miteinander kontaktiert, so daß die nach schaltungstechnischen Erfordernissen benötigten Ströme an die Schaltungselemente der Lagen geführt werden können.

. Durch die zueinander parallel von einem Randbereich zum gegenüberliegenden Randbereich einer Lage geführten Stromleitungen ergeben sich an vielen Flächenpunkten der Lage somit vergleichsweise hohe Leitungswiderstände, die zu relativ hohen Spannungsabfällen führen. Dadurch wird die Auslegung von integrierten Schaltungen über die Fläche designseitig erheblich beschränkt.

Da es sich bei den Stromleitungen um miniaturisierte, jeweils zueinander isoliert positive und negative Ströme führende Doppelleitungen handelt, sind die Ausbildungen von gitterförmig angeordneten Leitungen in einer einzelnen Lage, bei welchen Leitungen parallel von einem Randbereich zum gegenüberliegenden Randbereich und zugleich von den jeweils dazu querliegenden Randbereichen zum entsprechenden gegenüberliegenden geführt sind, technisch nicht realisierbar.

Aus diesem Grunde werden in der Praxis Lagen mit stromführenden Leitungen im Stapel häufig so eingelegt, daß die Leitungen einer Lage in einer Richtung verlaufen und die Leitungen einer anderen Lage in einer dazu rechtwinkligen Richtung.

Messungen zeigen, daß trotz dieser Anordnung die Leitungswiderstände vom Randbereich in den mittleren Flächenbereich der Lagen erheblich zunehmen und die Spannungsabfälle in von den Randbereichen ausgehenden, häufig konzentrischen Ringen zur Flächenmitte hin erheblich ansteigen, so daß sich schon in vergleichsweise geringen Entfernungen vom Rand Bereiche mit unakzeptabel hohen Spannungsabfällen ergeben.

Üblicherweise wird als oberste Lage eines eine integrierte Schaltung bildenden Stapels eine schwerpunktmäßig Stromleitungen aufweisende Lage angeordnet. Um die beschriebenen Nachteile der zur Flächenmitte hin steigenden Spannungsabfälle zumindest geringfügig ausräumen zu können, ist es bereits vorgeschlagen worden, zwei oberste und schwerpunktmäßig mit stromführenden Leitungen versehene Lagen anzuordnen, wobei die stromführenden Leitungen der einen Lage zueinander parallel von einem Randbereich zum gegenüberliegenden Randbereich verlaufen und die Stromleitungen der zweiten Lage von den dazu jeweils rechtwinklig liegenden Randbereichen zum entsprechend gegenüberliegenden. Da es sich bei integrierten Schaltungen um Massenprodukte handelt, stellt jedoch die Notwendigkeit der Anordnung einer zusätzlichen Lage einen erheblichen wirtschaftlichen Nachteil dar.

Alternative Verfahren zur Minimierung der Leitungswiderstände durch die Wahl des entsprechenden Leitungsmaterials, üblicherweise Aluminium, aus genannten Gründen aber auch Kupfer, Gold und dergleichen, haben sich als unbefriedigend und ebenfalls wirtschaftlich aufwendig erwiesen. Die Leitungen werden nach verschiedenen Verfahren auf den Layem gebildet, wobei zur Zeit insbesondere photochemische Metallisierungsverfahren verwendet werden.

Integrierte Schaltungen nach dem Stand der Technik sind beispielsweise aus den japanischen Druckschriften JP 08321551 A, JP 61043445 A und JP 03263854 A sowie aus dem US-Patent US-A-5,145,800 bekannt.

Ausgehend vom vorbeschriebenen Stand der Technik liegt der vorliegenden Erfindung die **Aufgabe** zugrunde, integrierte Schaltungen bereitzustellen, welche über die Fläche gegenüber herkömmlichen integrierten Schaltungen reduzierte Leitungswiderstände und damit Spannungsabfälle aufweisen und wirtschaftlich herstellbar sind. Des weiteren soll die Erfindung ein Verfahren bereitstellen, welches einerseits eine Reduzierung der Leitungswiderstände und damit der Spannungsabfälle über die Fläche bewirkt, andererseits auf einfache Weise und wirtschaftlich anwendbar ist.

Zur technischen **Lösung** dieser Aufgabe wird eine integrierte Schaltung nach Anspruch 1 und ein Verfahren nach Anspruch 8 Vorgeschlagen.

Die erfindungsgemäße Lehre bricht mit der Konvention, Stromleitungen einer Lage zueinander parallel von einem Randbereich zum gegenüberliegenden Randbereich zu führen. Vielmehr werden den in den Randbereichen angeordneten Verteilern Teilflächen der Lage zugeordnet und von den Verteilern Leitungsscharen in die Teilflächen geführt, wobei die Leitungen der unterschiedlichen Leitungsscharen zueinander nicht parallel verlaufen müssen. Auf diese Weise ist es möglich, in die unterschiedlichen Teilflächen einer Lage jeweils vom nächstliegenden Verteiler aus Stromleitungen zu führen, die gegenüber der herkömmlichen Bauweise in bezug auf die Teilfläche kürzere Leitungslängen aufweisen und somit verringerte Leitungswiderstände, was zur Verringerung der Spannungsabfälle führt. Darüber hinaus kann die Anzahl der Layer in einer integrierten Schaltung verringert werden, da es nicht mehr erforderlich ist, zur Erzielung einer verbesserten Stromverteilung über die Fläche wenigstens zwei Lagen mit zueinander rechtwinklig verlaufenden Stromleitungen zu verwenden. Von den an den Rändern des Layers liegenden Verteilern werden Stromleitungen derart in den mittleren Flächenbereich der Layerfläche geführt, so daß in einer Umgebung um jeden Flächenpunkt des mittleren Flächenbereiches wenigstens eine Stromleitung angeordnet ist, die auf kürzestem Wege mit einem nächstliegenden Verteiler verbunden ist. Auf diese Weise wird eine Stromversorgung auch in den mittleren Flächenbereich der unterschiedlichen Layer einer integrierten Schaltung bei reduziertem Stromwiderstand und damit verringerten Spannungsabfällen sichergestellt.

In vorteilhafter Weise sind die Leitungen einer Teilfläche zueinander parallel angeordnet, so daß sich nach schaltungstechnischen Bedürfnissen in bezug auf Teilflächen die Stromzuführung nach dem Gesichtspunkt der Spannungsabfälle optimieren läßt. Gemäß einem weiteren vorteilhaften Vorschlag der Erfindung können die Leitungen verschiedener Teilflächen an den Endpunkten miteinander kontaktiert sein, so daß die Stromversorgung in die entsprechenden Bereiche besonders günstig ist, da praktisch eine Zweifachversorgung im Bereich der entsprechenden Flächenpunkte vorliegt.

Mit der Erfindung wird vorgeschlagen, einen Layer in vier Teilflächen auszubilden, so daß sich vier Leitungsscharen ergeben, die jeweils mit einem an einem der vier Ränder der Lage angeordneten Verteiler verbunden sind. In vorteilhafter Weise können die Leitungen der Leitungsscharen vom am Rand der Lage liegenden Verteiler bis zur Diagonalen der Lagenfläche geführt sein.

Durch die erfindungsgemäße Ausgestaltung der Lage bzw. des Layers mit stromführenden Leitungen wird zusätzlich auch der Vorteil erreicht, daß die unterschiedlichen Verteiler der Lage gleichmäßig belastet werden, während bei den nach dem Stand der Technik ausgebildeten Layem jeweils im wesentlichen nur zwei an gegenüberliegenden Randbereichen ausgebildeten Verteiler belastet sind. Es läßt sich somit eine nahezu symmetrische Belastung der Verteilerpunkte erreichen.

Insgesamt können nach der Erfindung gemäß einem vorteilhaften Vorschlag die Verteiler und die Stromleitungen derart auf einem Layer angeordnet werden, daß sich in der Umgebung eines jeden Flächenpunktes eine Stromversorgung mit minimalem elektrischen Widerstand ergibt.

In vorteilhafter Weise wird die mit den Teilflächen geführten Stromleitungsscharen versehene Lage als oberste Lage der integrierten Schaltung angeordnet, so daß sich von hier durch eine Durchkontaktierung in die darunter liegenden Lagen eine verbesserte Stromversorgung ergibt.

Gemäß einem vorteilhaften Vorschlag der Erfindung wird die mit in Teilflächen mit Leitungsscharen versehene Lage ausschließlich mit Stromleitungen versehen. Dies begünstigt eine wirtschaftliche Herstellung.

Nach dem erfindungsgemäßen Verfahren hergestellte integrierte Schaltungen sind in bezug auf die Auslegung der Schaltung, d. h. Anordnung von Stromverbrauchern über die Layerflächen gegenüber dem Stand der Technik erheblich flexibler, da die Spannungsabfälle aufgrund von durch Leitungslängen bewirkten Widerständen in den unterschiedlichen Teilflächen reduziert sind. Darüber hinaus lassen sich die mit den Teilflächen geführten Stromleitungen versehenen Lagen auf einfache Weise herstellen und es kann auf die Verwendung von einer Mehrzahl alternierend angeordneten Layem mit stromführenden Leitungen verzichtet werden, wodurch die Herstellung der integrierten Schaltungen erheblich wirtschaftlicher wird.

Nach dem erfindungsgemäßen Verfahren hergestellte integrierte Schaltungen zeichnen sich dadurch aus, daß sie wenigstens einen Layer aufweisen, bei welchem die Stromleitungen derart angeordnet sind, daß sich Teilflächen mit Leitungsscharen ergeben, die jeweils mit dem zur Teilfläche nächstliegenden im Randbereich des Layers angeordneten Verteiler kontaktiert sind. Derartige integrierte Schaltungen weisen insbesondere im mittleren Flächenbereich, also auf der Strecke zwischen Rand und Fläche, in bezug auf die Layer erheblich reduzierte Widerstände und damit erheblich reduzierte Spannungsabfälle auf. Darüber hinaus weisen erfindungsgemäße . integrierte Schaltungen insgesamt weniger Lagen auf, da zumindest auf die Verwendung von zwei mit jeweils rechtwinklig zueinander verlaufenden Stromleitungen versehene Lagen verzichtet werden kann. Eine Lage läßt sich auf diese Weise in jedem Anwendungsfall einsparen, woraus sich in bezug auf die Massenproduktion erhebliche wirtschaftliche Vorteile ergeben.

Weitere Vorteile und Merkmale der Erfindung ergeben sich aus der folgenden Beschreibung anhand der Figuren. Dabei zeigen:
- Fig. 1: eine Draufsicht auf eine schematisierte Darstellung eines Ausführungsbeispiels für einen erfindungsgemäß ausgebildeten Layer und
- Fig. 2: eine Draufsicht auf eine schematisierte Darstellung auf einem Layer mit stromführenden Leitungen nach dem Stand der Technik.

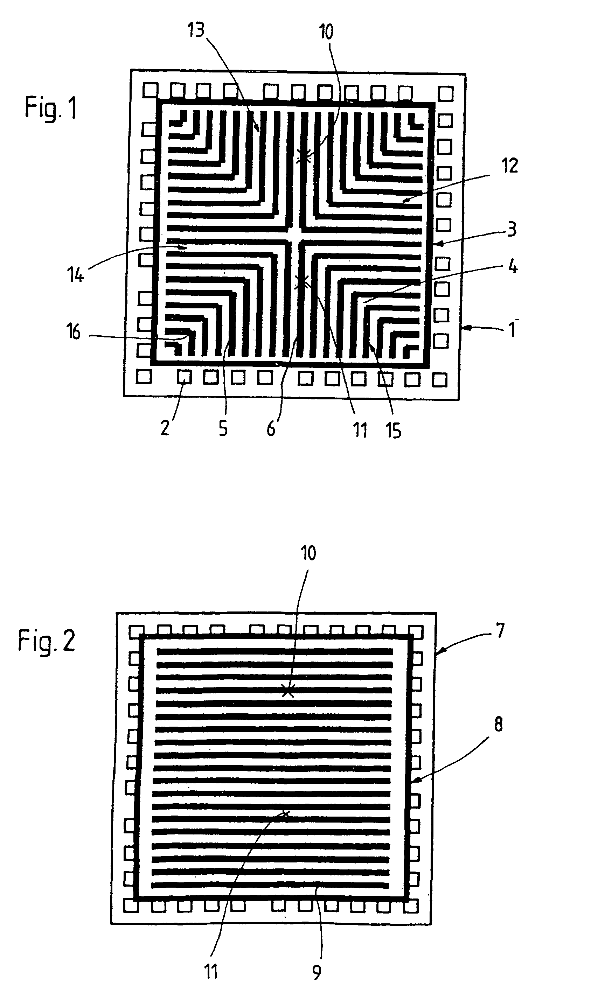

Fig. 1 zeigt einen Layer 1, der quadratisch ausgebildet ist und umlaufend Kontaktierungspunkte 2 aufweist. Darüber hinaus sind im Randbereich im wesentlichen parallel zum Rand verlaufend Verteiler 3 ausgebildet. Diese stellen Stromverteilerschienen dar, an welche stromführende Leitungen angeschlossen und in dem Bereich der Fläche geführt sind. Mit 4 sind die Diagonalen der Layerfläche bezeichnet. Im gezeigten Ausführungsbeispiel sind Stromleitungen 5 jeweils von dem am Rand liegenden Verteiler zueinander parallel bis zur Diagonalen geführt. Soweit das Schaltungsraster der Leitungen unterschiedlicher Teilflächen dies zulassen, sind die stromführenden Leitungen unterschiedlicher Teilflächen im Bereich der Diagonalen miteinander kontaktiert, so daß sich die Kontaktpunkte 16 ergeben. In jeder der im Ausführungsbeispiel gebildeten vier Teilflächen 12, 13, 14 und 15 ist somit in der Umgebung eines jeden Flächenpunktes eine Stromleitung angeordnet, die auf kürzestem Wege mit dem zum Flächenpunkt nächstliegenden Verteiler verbunden ist. Die direkt zur Flächenmitte führenden Stromleitungen sind im gezeigten Ausführungsbeispiel ohne Kontaktierung bis in die direkte Umgebung des Flächenmittelpunktes geführt, so daß sich auch hier in einem Umgebungsbereich um den Flächenmittelpunkt jeweils Stromleitungen mit kürzester Verbindung zum nächstliegenden Verteiler ergeben.

Bei einem nach dem Stand der Technik hergestellten Layer 7 gemäß Fig. 2 ist die Anordnung von Kontaktpunkten und umlaufenden Verteilern 8 entsprechend. Jedoch sind die Stromleitungen über die gesamte Fläche zueinander parallel von dem im einen Randbereich liegenden Verteiler zu dem im gegenüberliegenden Randbereich liegenden Verteiler geführt.

Vergleicht man nun unterschiedliche Flächenpunkte der in den Fig. 1 und 2 gezeigten Ausführungen, so zeigt sich, daß die Flächenpunkte 10 und 11 in dem in Fig. 1 gezeigten, erfindungsgemäßen Ausführungsbeispiel jeweils im Bereich von Leitungen 5, 6 liegen, die eine kürzere Verbindung zum nächstliegenden Verteiler aufweisen, als im nach dem Stand der Technik gebildeten Aufbau gemäß Fig. 2. Durch die kürzeren Leitungslängen ergeben sich daher verringerte Widerstände und damit reduzierte Spannungsabfälle.

Das gezeigte Ausführungsbeispiel dient nur der Erläuterung und ist nicht beschränkend. Insbesondere können die Anordnungen der Verteiler und der in Teilflächen geführten Stromleitungen auch in anderen Positionen und Verläufen angeordnet werden, so daß sich jeweils in einem Umgebungsbereich eines Flächenpunktes eines Layers Stromleitungen befinden, die auf kürzestem Weg mit dem nächstliegenden Verteiler verbunden sind.

### Bezugszeichenliste

- 1: Layer
- 2: Kontaktpunkte
- 3: Verteiler
- 4: Diagonale
- 5: Stromleitung
- 6: Stromleitung
- 7: Layer
- 8: Verteiler
- 9: Stromleitung
- 10: Flächenpunkt
- 11: Flächenpunkt
- 12: Teilfläche
- 13: Teilfläche
- 14: Teilfläche
- 15: Teilfläche
- 16: Kontaktpunkt

## Patentansprüche

1. Integrierte Schaltung mit einem Stapel aus einer Vielzahl von einzelnen Lagen aus Schaltungselementen, Stromleitungen und/oder Signalleitungen aufweisenden Flächenelementen, wobei wenigstens eine Lage (1) Stromleitungen (5, 6) aufweist, wobei die Stromleitungen (5, 6) einer Lage mit im Randbereich der Lage ausgebildeten Verteilern (3) und die Stromleitungen verschiedener Lagen elektrisch miteinander verbunden sind,
**dadurch gekennzeichnet, daß**
in wenigstens einer Lage die Stromleitungen zueinander isoliert positive und negative Ströme führende Doppelleitungen sind, und Leitungsscharen aufweisende Teilflächen (12, 13, 14, 15) ausgebildet sind und die Leitungsscharen der Teilflächen mit an jeweils einem Rand der Teilflächen angeordneten Verteilern verbunden und derart angeordnet sind, daß in der Umgebung jeden Flächenpunktes wenigstens eine Stromleitung angeordnet ist, die auf kürzestem Wege mit dem nächstliegenden Verteiler verbunden ist, damit sich zwischen jedem Flächenpunkt und den Verteilern ein minimaler Stromwiderstand ergibt.

2. Integrierte Schaltung nach Anspruch 1, **dadurch gekennzeichnet, daß** die Stromleitungen einer Lage zueinander parallel angeordnet sind.

3. Integrierte Schaltung nach einem der vorhergehenden Ansprüche, **dadurch gekennzeichnet, daß** die Stromleitungen verschiedener Teilflächen an ihren in der Fläche liegenden Endpunkten miteinander kontaktiert sind.

4. Integrierte Schaltung nach einem der vorhergehenden Ansprüche, **dadurch gekennzeichnet, daß** in einer Lage vier Teilflächen ausgebildet sind, deren Leitungsscharen mit einem an jeweils einem Rand der Lage angeordneten Verteiler verbunden sind.

5. Integrierte Schaltung nach einem der vorhergehenden Ansprüche, **dadurch gekennzeichnet, daß** die Leitungen einer Leitungsschar jeweils von einem am Rand der Lage angeordneten Verteiler bis zur jeweiligen Diagonalen der Lagenfläche geführt sind.

6. Integrierte Schaltung nach einem der vorhergehenden Ansprüche, **dadurch gekennzeichnet, daß** die mit in den Teilflächen angeordneten Leitungsscharen gebildete Lage als oberste Lage des Lagenstapels angeordnet ist.

7. Integrierte Schaltung nach einem der vorhergehenden Ansprüche, **dadurch gekennzeichnet, daß** die. mit in den Teilflächen angeordneten Leitungsscharen versehene Lage ausschließlich mit Stromleitungen versehen ist.

8. Verfahren zur Herstellung einer integrierten Schaltung, bei welchem ein Stapel aus einer Vielzahl von einzelnen Lagen aus Schaltungselementen, Stromleitungen und/oder Signalleitungen aufweisenden Flächenelementen gebildet wird, wobei die Stromleitungen (5, 6) einer Lage (1) mit im Randbereich der Lage ausgebildeten Verteilern (3) und die Stromleitungen verschiedener Lagen elektrisch miteinander verbunden werden,
**dadurch gekennzeichnet, daß**
in wenigstens einer Lage die Stromleitungen zueinander isoliert positive und negative Ströme führende Doppelleitungen sind, und Leitungsscharen aufweisende Teilflächen (12, 13, 14, 15) ausgebildet werden,
die Leitungsscharen der Teilflächen mit an jeweils einem Rand der Teilflächen angeordneten Verteilern verbunden und derart angeordnet werden, daß in der Umgebung jeden Flächenpunktes wenigstens eine Stromleitung angeordnet wird, die auf kürzestem Wege mit dem nächstliegenden Verteiler verbunden ist, damit sich zwischen jedem Flächenpunkt und den Verteilern ein minimaler Stromwiderstand ergibt.

## Claims

1. An integrated circuit including a stack of a plurality of surface elements including individual layers comprising circuit elements, current lines and/or signal lines, at least one layer (1) having current lines (5, 6), the current lines (5, 6) of one layer being connected to distributors (3) formed in the edge region of the layer and the current lines of different layers being electrically connected together, **characterised in that**, in at least one layer, the current lines are double lines, which are insulated from one another and conduct positive and negative currents, and component surfaces having conductor bands are formed and the conductor bands of the component areas are connected to distributors arranged at a respective edge of the component surfaces and are so arranged that at least one current conductor is arranged in the vicinity of each surface point which is connected by the shortest route to the closest distributor so that a minimum current resistance is produced between each surface point and the distributors.

2. An integrated circuit as claimed in claim 1, **characterised in that** the current lines of one layer are arranged parallel to one another.

3. An integrated circuit as claimed in one of the preceding claims, **characterised in that** the current lines of different component surfaces are in contact with one another at their end points situated in the surface.

4. An integrated circuit as claimed in one of the preceding claims, **characterised in that** formed in one layer there are four component surfaces, the conductor bands of which are connected to a distributor arranged at a respective edge of the layer.

5. An integrated circuit as claimed in one of the preceding claims, **characterised in that** the conductors of one conductor band extend from a respective distributor arranged at the edge of the layer to the respective diagonal of the layer surface.

6. An integrated circuit as claimed in one of the preceding claims, **characterised in that** the layer formed with conductor bands arranged in the component areas is arranged as the uppermost layer of the layer stack.

7. An integrated circuit as claimed in one of the preceding claims, **characterised in that** the layer provided with conductor bands arranged in the component surfaces is provided exclusively with current lines.

8. A method of manufacturing an integrated circuit, in which a stack is formed of a plurality of individual surface elements having layers comprising circuit elements, current lines and/or signal lines, the current lines (5, 6) of one layer (1) being connected to distributors (4) formed in the edge region of the layer and the current lines of different layers being electrically connected together, **characterised in that**, in at least one layer, the current lines are double lines, insulated from one another and conducting positive and negative currents, and component surfaces (12, 13, 14, 15) having conductor bands are formed, the conductor bands of the component surfaces are connected to distributors arranged at a respective edge of the component surfaces and are so arranged that arranged in the vicinity of each surface point there is at least one current line, which is connected via the shortest distance to the closest distributor in order that a minimal current resistance is produced between each surface point and the distributors.

## Revendications

1. Circuit intégré avec une pile composée d'une pluralité de couches individuelles d'éléments de surface présentant des éléments de circuit, des lignes électriques et/ou des circuits d'acheminement des signaux, sachant qu'au moins une couche (1) présente des lignes électriques (5, 6), les lignes électriques (5, 6) d'une couche étant raccordées à des tableaux de distribution (3) formés dans la zone du bord de la couche et les lignes électriques de différentes couches sont raccordées ensemble électriquement, **caractérisé en ce que** dans au moins une couche, les lignes électriques sont des lignes doubles isolées l'une par rapport à l'autre et véhiculant des courants positifs et négatifs, et **en ce que** des surfaces partielles (12, 13, 14, 15) présentant des assemblages de lignes sont formées, et **en ce que** les assemblages de lignes des surfaces partielles sont en liaison avec des tableaux de distribution aménagés sur respectivement un bord des surfaces partielles et sont disposés de manière à ce que, dans l'environnement de chaque point de la surface, au moins une ligne électrique soit aménagée, laquelle est raccordée, en empruntant le chemin le plus court, au tableau de distribution le plus proche, afin qu'il y ait formation d'une résistance électrique minimale entre chaque point de la surface et les tableaux de distribution.

2. Circuit intégré selon la revendication 1, **caractérisé en ce que** les lignes électriques d'une couche sont disposées parallèlement l'une par rapport à l'autre.

3. Circuit intégré selon l'une quelconque des revendications précédentes, **caractérisé en ce que** les lignes électriques de différentes surfaces partielles sont contactées ensembles à leurs points d'extrémité situés dans la surface.

4. Circuit intégré selon l'une quelconque des revendications précédentes, **caractérisé en ce que** quatre surfaces partielles sont développées dans une couche, dont les assemblages de lignes sont raccordés à un tableau de distribution respectivement disposé sur un bord de la couche.

5. Circuit intégré selon l'une quelconque des revendications précédentes, **caractérisé en ce que** les lignes d'un assemblage de lignes sont menées respectivement d'un tableau de distribution disposé sur le bord de la couche jusqu'à la diagonale respective de la surface des couches.

6. Circuit intégré selon l'une quelconque des revendications précédentes, **caractérisé en ce que** la couche avec les assemblages de lignes aménagés dans les surfaces partielles, est disposée de sorte à être la couche supérieure de la pile de couches.

7. Circuit intégré selon l'une quelconque des revendications précédentes, **caractérisé en ce que** la couche pourvue des assemblages de lignes aménagés dans les surfaces partielles est exclusivement pourvue de lignes électriques.

8. Procédé pour la fabrication d'un circuit intégré, dans lequel une pile est formée d'une pluralité de couches individuelles d'éléments de surface présentant des éléments de circuit, des lignes électriques et/ou des circuits d'acheminement des signaux, les lignes électriques (5, 6) d'une couche (1) étant raccordées à des tableaux de distribution (3) formés dans la zone du bord de la couche, et les lignes électriques de différentes couches étant raccordées électriquement entre elles, **caractérisé en ce que** dans au moins une couche (3) les lignes électriques sont des lignes doubles isolées les unes par rapport aux autres et transportant des courants positifs et négatifs, et **en ce que** des surfaces partielles (12, 13, 14, 15) présentant des assemblages de lignes sont formées, **en ce que** les assemblages de lignes des surfaces partielles sont raccordés avec des tableaux de distribution respectivement disposés sur le bord des surfaces partielles et sont disposés de manière à ce que dans l'environnement de chaque point de la surface, au moins une ligne électrique soit disposée, laquelle est raccordée, en empruntant le chemin le plus court, au tableau de distribution le plus proche, afin qu'une résistance électrique minimale soit obtenue entre chaque point de la surface et les tableaux de distribution.
